# EUROPÄISCHE PATENTSCHRIFT

(11) **EP 0 418 788 B1**
(45) Veröffentlichungstag und Bekanntmachung des Hinweises auf die Patenterteilung: **12.01.1994**
(21) Anmeldenummer: 90117876.4
(22) Anmeldetag: 17.09.1990
(51) Int. Cl.: H05K 7/14

(54) **Schrankförmiges Gehäuse für elektronische Geräte**
Cabinet enclosure for electronical apparatus
Logement en forme d'armoire pour appareillages électroniques

(30) Priorität: 20.09.1989 DE 8911215 U
(43) Veröffentlichungstag der Anmeldung: 27.03.1991
(73) Patentinhaber: Siemens Nixdorf Informationssysteme Aktiengesellschaft, 33102 Paderborn (DE)
(72) Erfinder: Hellwig, Bernhard, D-8034 Germering (DE); Müller, Walter, D-8902 Neusäss (DE)
(74) Vertreter: Fuchs, Franz-Josef, Dr.-Ing.

(56) Entgegenhaltungen:
- US-A- 3 662 225
- US-A- 4 473 263
- US-A- 4 862 400
- NAVY TECHNICAL DISCLOSURE BULLETIN, Bd. 12, Nr. 3, März 1987, ARLINGTON US Seiten 1 - 4; J. HECKMAN: 'COMPACT PACKAGING OF PRINTED CIRCUIT CARDS'

## Beschreibung

Größere elektronische Geräte, wie z.B. Geräte von großen Datenverarbeitungsanlangen, sind in der Regel in schrankförmigen Gehäusen untergebracht. Geräte dieser Art haben meist eine Vielzahl von äußeren Leitungsverbindungen, über die sie mit anderen Geräten, wie z.B. Peripheriegeräten verbunden werden. Die zu nehmende integrationsdichte solcher elektronischer Geräte erfordert auch eine hohe Packungsdichte der Stecker für solche externe Leitungen bei meist gleichbleibender Anschlußfläche der Stecker innerhalb der Geräte.

Die externen Leitungen und ihre Stecker müssen gut zugänglich sein, um bei der Aufstellung der Geräte leicht und mit geringem Zeitaufwand montiert werden zu können. Probleme können aber dann auftreten, wenn die schrankförmigen Gehäuse eine feste Rückwand besitzen, z.B. weil sie Rückwand an Rückwand mit anderen Geräten aufgestellt werden und der Zugang zu den externen Leitungen und ihren Steckern über z.B. an den beiden Seiten des Gehäuses angeordnete Türen erfolgen muß.

Für derartige schrankförmige Gehäuse ist es bekannt, eine sogenannte Steckerwand vorzusehen, auf der die Stecker für die externen Leitungen angebracht sind. Bisher wurden Steckerwände als ebene Blechtafeln mit diversen Durchbrüchen für die Stecker im Inneren des schrankförmigen Gehäuses vorgesehen. Durch diese Art der Anordnung wurde aber die Montagefreundlichkeit stark eingeschränkt. Ferner wurden schrankförmige Gehäuse benötigt, die besonders tief waren, um die Zugänglichkeit zu der Steckerwand und den dort montierten Steckern zu gewährleisten. Die Beschriftung der einzelnen Steckerfelder auf der Steckerwand war meist sehr schlecht lesbar und der Zeitaufwand beim Tausch von Steckern besonders groß.

Der Erfindung lag daher die Aufgabe zugrunde, für schrankförmige Gehäuse eine neue Ausgestaltung der Steckerwand zu schaffen, bei der insbesondere die Adressenbeschriftung auf der Steckerwand für die einzelnen Leitungen und Stecker von außen gut lesbar sein sollte und bei der ferner ein Leitungstausch leicht und ohne großen Zeitaufwand durchgeführt werden kann.

Erfindungs gemäß wird diese Aufgabe dadurch gelöst, daß die Stekkerwand nach Art eines Harmonikabalges gefaltet ausgebildet ist, wobei die Stecker Jeweils auf den nach außen weisenden Flächen der Falten angeordnet sind. Ein guter Kompromiß zwischen Raumausnutzung und leichter Zugänglichkeit bei relativ geringer Montagetiefe ergibt sich, wenn die Faltung so ausgebildet ist, daß die Achsen der montierten Stecker von der Wandmitte aus gesehen symmetrisch beidseitig um 30° nach außen gedreht liegen. Auf Grund dieser Lage der Stecker auf der Stekkerwand sind die Befestigungsschrauben der einzelnen Stecker sowie ihre Beschriftungsfelder gut einsehbar.

Durch die Faltung der Steckerwand wird außerdem eine starke Versteifung der Wand erreicht, und die Blechstärke für die Steckerwand kann somit reduziert werden.

Eine besonders vorteilhafte Ausgestaltung ergibt sich, wenn die gefaltete Steckerwand aus zwei gleichen, spiegelsymmetrisch angeordneten Hälften besteht und Jede der beiden Hälften auf einer Seite neben dem gefaltet ausgebildeten Steckeraufnahmefeld einen flachen Randstreifen besitzt zum spiegelsymmetrischen Verbinden in der Mitte der Steckerwand.

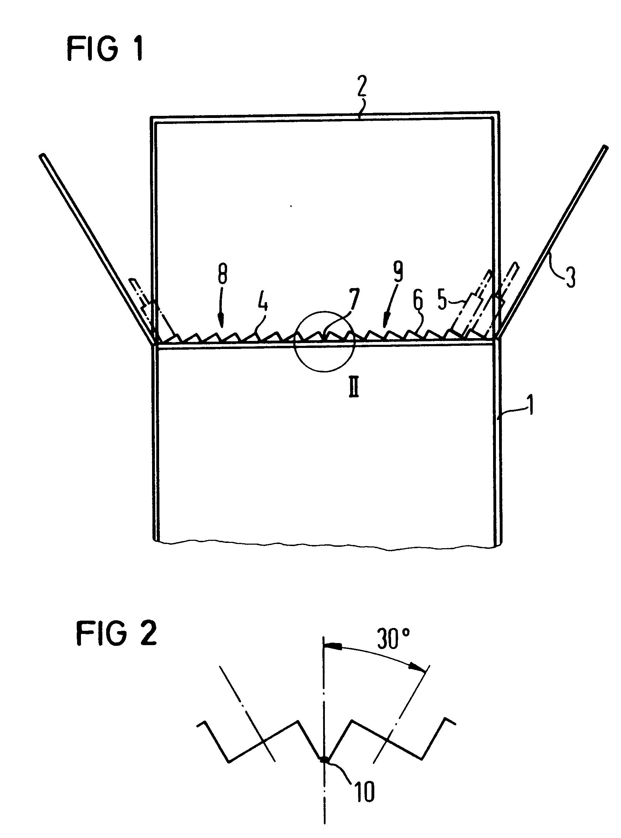

FIG 1 zeigt als Ausführungsbeispiel in schematischer Darstellung den hinteren Teil eines schrankförmigen Gehäuses 1 für elektronische Geräte. Das Gehäuse besitzt eine feste Rückwand 2 und im dargestellten Beispiel zwei an den beiden hinteren Teilen der Seitenwände des Gehäuses 1 angeordnete Türen 3 für den Zugang zur Steckerwand 4. Die Steckerwand 4 selbst ist nach Art eines Harmonikabalges gefaltet ausgebildet, und die Stecker 5 sind auf den nach außen weisenden Flächen 6 der Falten angeordnet. Die Faltung der Steckerwand ist im dargestellten Beispiel so ausgebildet, daß die Achsen der montierten Stecker 5 von der Wandmitte 7 aus symmetrisch beidseitig um 30° nach außen gedreht liegen. Auf diese Weise können zum einen die Befestigungsschrauben für die Stecker 5 auf den nach außen weisenden Flächen 6 der Falten gut erreicht und die Beschriftungen für die Stecker von außen her durch die Türen leicht gelesen werden.

Eine besonders vorteilhafte Ausgestaltung der Steckerwand des neuerungsgemäßen schrankförmigen Gehäuses ergibt sich, wenn die gefaltete Steckerwand 4 aus zwei gleichen, separaten, spiegelsymmetrisch angeordneten Hälften 8 bzw. 9 besteht. Durch eine solche Ausgestaltung der Steckerwand läßt sich bei der Herstellung derselben eine wesentliche Erleichterung dadurch erzielen, daß das Faltwerkzeug für die gesamte Wand nur noch halb so groß sein muß und außerdem nur Faltungen in einer Richtung ausgeführt werden müssen, was bei Ausgestaltung der gefalteten Stekkerwand als Ganzes nicht möglich wäre. Hierzu ist es zweckmässig, daß jede der beiden Hälften 8 bzw. 9 auf einer Seite neben dem gefaltet ausgebildeten Steckeraufnahmefeld einen flachen Randstreifen 10 besitzt, der zum spiegelsymmetrischen Verbinden der beiden Hälften in der Mitte der Steckerwand dient. FIG 2 zeigt eine solche Ausgestaltung.

## Patentansprüche

1. Schrankförmiges Gehäuse für elektronische Geräte, insbesondere Geräte von Datenverarbeitungsanlagen, mit einer im Inneren des mit einer festen Rückwand versehenen schrankförmigen Gehäuses im wesentlichen parallel zur Rückwand angeordneten Stekkerwand und vorzugsweise zwei an den beiden Seitenwänden des Gehäuses angeordneten Türen für den Zugang zu der Steckerwand, **dadurch gekennzeichnet,** daß die Stekkerwand (4) nach Art eines Harmonikabalges gefaltet ausgebildet ist.

2. Gehäuse nach Anspruch 1, **dadurch gekennzeichnet,** daß die Stecker (5) auf den nach außen weisenden Flächen (6) der Falten der Steckerwand (4) angeordnet sind.

3. Gehäuse nach Anspruch 2, **dadurch gekennzeichnet,** daß die Faltung der Steckerwand (4) so ausgebildet ist, daß die Achsen der montierten Stecker (5) von der Wandmitte (7) aus symmetrisch beidseitig um 30° nach außen geschwenkt liegen.

4. Gehäuse nach einem der Ansprüche 1 bis 3, **dadurch** **gekennzeichnet**, daß die gefaltete Steckerwand (4) aus zwei gleichen, separaten, spiegelsymmetrisch angeordneten Hälften (8,9) besteht.

5. Gehäuse nach Anspruch 4, **dadurch gekennzeichnet,** daß Jede der beiden Hälften (8,9) auf einer Seite neben dem gefaltet ausgebildeten Steckeraufnahmefeld einen Randstreifen (10) zum spiegelsymmetrischen Verbinden in der Mitte der Steckerwand besitzt.

## Claims

1. Cabinet enclosure for electronic apparatus, especially apparatus of data processing systems, having a plug panel disposed in the interior of the cabinet enclosure provided with a fixed rear wall, arranged substantially parallel to the rear wall, and preferably two doors, disposed at the two side walls of the enclosure, for access to the plug panel, characterised in that the plug panel (4) is designed to be folded in the manner of an accordion bellows.

2. Enclosure according to Claim 1, characterised in that the plugs (5) are disposed on the outwardly pointing surfaces (6) of the folds of the plug panel (4).

3. Enclosure according to Claim 2, characterised in that the folding of the plug panel (4) is designed so that the axes of the mounted plugs (5) are situated such that they are swung outwards from the panel centre (7) symmetrically on both sides through 30°.

4. Enclosure according to one of Claims 1 to 3, characterised in that the folded plug panel (4) comprises two identical, separate halves (8, 9) which are disposed with mirror image symmetry.

5. Enclosure according to Claim 4, characterised in that each one of the two halves (8, 9) possesses, on one side alongside the plug reception field designed to be folded, an edging strip (10) for connection with mirror image symmetry at the centre of the plug panel.

## Revendications

1. Boîtier en forme d'armoire pour des appareils électroniques, notamment des appareils d'installations de traitement de données comportant une paroi porte-connecteurs, disposée, à l'intérieur du boîtier en forme d'armoire pourvu d'une paroi arrière fixe, sensiblement parallèlement à cette paroi arrière, et de préférence, deux portes disposées sur les deux parois latérales du boitier et permettant l'accès à la paroi porte-connecteurs, caractérisé par le fait que la paroi porte-connecteurs (4) est agencée avec une forme pliée à la façon d'un soufflet d'accordéon.

2. Boîtier suivant la revendication 1, caractérisé par le fait que les connecteurs (5) sont disposés sur les surfaces (6), tournées vers l'extérieur, des plis de la paroi porte-connecteurs (4).

3. Boîtier suivant la revendication 2, caractérisé par le fait que les plis de la paroi porte-connecteurs (4) sont agencés de telle sorte que les axes des connecteurs montés (5) sont pivotés symétriquement des deux côtés, de 30° vers l'extérieur, à partir du milieu (7) de la paroi.

4. Boitier suivant l'une des revendications 1 à 3, caractérisé par le fait que la paroi porte-connecteurs (4) repliée est constituée de deux moitiés identiques séparées (8,9), qui sont disposées symétriquement.

5. Boîtier suivant la revendication 4, caractérisé par le fait que chacune des deux moitiés (8,9) possède d'un côté, à côté de la zone repliée logeant les connecteurs, une bande marginale (10) pour l'établissement de la liaison symétrique au centre de la paroi porte-connecteurs.
